# EUROPEAN PATENT APPLICATION

(11) **EP 4 767 895 A1**
(43) Date of publication of application: **01.07.2026**
(21) Application number: 24856714.1
(22) Date of filing: 08.08.2024
(51) Int. Cl.: A47L 9/28, H04M 1/72412, H01M 10/42, H01M 10/48, G01R 31/385, G01R 19/165, G01R 31/36

(54) **CLEANER AND CONTROL METHOD OF CLEANER**

(30) Priority: 22.08.2023 KR 20230110102
(71) Applicant: LG Electronics Inc., Yeongdeungpo-gu Seoul 07336 (KR)
(72) Inventor: PARK, Heegu, Seoul 08592 (KR); SHIN, Seungin, Seoul 08592 (KR); HAN, Seonghoon, Seoul 08592 (KR)
(74) Representative: Vossius & Partner Patentanwälte Rechtsanwälte mbB
(86) International application number: PCT/KR2024/011769
(87) International publication number: WO 2025/042102

(57) **Abstract**

The present invention comprises: a battery; a suction motor which is operated by the power of the battery; a voltage sensor which measures a voltage of the battery; and a control unit which determines on the basis of the voltage of the battery whether to replace the battery.

## Description

### [Technical Field]

The present disclosure relates to a cleaner and, more particularly, to a technology for informing of battery replacement of a cleaner.

### [Background Art]

Cleaners may be classified into manual cleaners for performing cleaning while being directly moved by a user, and robot cleaners that perform cleaning while autonomously traveling. Further, the manual cleaners may be classified, depending on the types of the cleaners, a canister cleaner, an upright cleaner, a handheld cleaner, a stick-type cleaner, etc.

Cleaners include an impeller and a suction motor that rotates the impeller in order to provide a driving force for dust suction.

In the case of the handheld cleaner, in preparation for the difficulty in completing cleaning of a cleaning area with only one battery, cleaning may be completed by replacing the battery with a spare battery.

Some users merely place a spare battery on an auxiliary charging stand without using it, and in some cases, the spare battery is removed and separately stored in storage for an extended period.

When a battery is not used for reasons of PL safety, the battery enters a sleep mode, and when the battery is not used for an extended period, the battery is self-discharged to a minimum operating voltage, thereby losing its function as a battery and becoming unable to be reused.

When a main battery fails to operate and a user attaches a self-discharged spare battery to a cleaner, the cleaner fails to operate, which results in many consumer complaints.

In some patents of the related art, a replacement timing is determined by determining battery life on the basis of a charging time and the number of charging cycles of a battery, and the replacement timing is informed to a user. Therefore, in the related art, when two batteries are alternately replaced and used, since no method is provided to prevent discharge of a spare battery, there is a problem that a spare battery is discharged.

### [Prior Art Document]

### [Patent Document]

Korean Patent Application Publication No. 20040057721

### [Disclosure]

### [Technical Problem]

The first objective of the present disclosure is to provide a cleaner that prevents a spare battery of the cleaner from being discharged when the spare battery is not replaced for an extended period.

The second objective is to provide a cleaner that informs a user of replacement in various ways when a spare battery of the cleaner is not replaced for an extended period.

A third objective of the present disclosure is to provide a cleaner that accurately determines battery replacement of the cleaner using only a voltage sensor of the battery.

### [Technical Solution]

In order to achieve the objectives described above, the present disclosure determines whether the battery has been replaced on the basis of a change in the voltage of a battery by monitoring the voltage of the battery.

In detail, the present disclosure includes a battery, a suction motor configured to be operated by power of the battery, a voltage sensor configured to measure a voltage of the battery, and a control unit configured to determine whether the battery has been replaced on the basis of the voltage of the battery.

The control unit may determine that the battery has been replaced when the voltage of the battery changes beyond a preset first range within a preset first time.

The present disclosure further includes an output unit configured to display a state of the cleaner, wherein, when the control unit determines that the battery has been replaced, the control unit may output a control command to cause the output unit to display a signal enabling a user to recognize replacement of the battery.

The control unit may determine that the battery has not been replaced when the voltage of the battery changes within a preset first range within a preset first time.

The control unit may output a control command to cause the output unit to display a signal enabling a user to recognize that the battery has not been replaced, when a state in which the battery has not been replaced is maintained for a second time longer than the first time.

Further, the present disclosure further includes a terminal connected with the cleaner through a wireless communication method, wherein the control unit may output a control command to cause the terminal to display a signal enabling a user to recognize that the battery has not been replaced, when a state in which the battery has not been replaced is maintained for a second time longer than the first time.

The control unit may determine that the battery has been replaced when a voltage difference between an off voltage of the battery at a time point at which the suction motor is turned off and an on voltage of the battery at a time point at which the suction motor is turned on again after being turned off exceeds a first voltage difference.

When the control unit determines that the battery has been replaced, the control unit may output a control command to cause the output unit to display a signal enabling a user to recognize replacement of the battery.

The control unit may determine that the battery has not been replaced when the voltage difference is smaller than the first voltage difference.

The control unit may output a control command to cause the output unit to display a signal enabling a user to recognize that the battery has not been replaced, when a state in which the battery has not been replaced is maintained for a second time.

The control unit may output a control command to cause the terminal to display a signal enabling a user to recognize that the battery has not been replaced, when a state in which the battery has not been replaced is maintained for a second time.

The control unit may output a control command to cause the output unit to display a signal enabling a user to recognize that the battery has not been replaced, when one cycle is defined as a sequence in which the suction motor is turned off and then turned on again, and when a state in which the battery has not been replaced exceeds a preset number of cycles.

The control unit may output a control command to cause the terminal to display a signal enabling a user to recognize that the battery has not been replaced, when one cycle is defined as a sequence in which the suction motor is turned off and then turned on again, and when a state in which the battery has not been replaced exceeds a preset number of cycles.

The control unit may determine that the battery has been replaced, when a voltage difference between an off voltage of the battery at a time point at which the suction motor is turned off and an on voltage of the battery at a time point at which the suction motor is turned on after the suction motor is turned off and the battery is charged exceeds a first voltage difference.

The control unit may output a control command to cause the output unit to display a signal enabling a user to recognize that the battery has not been replaced, when one cycle is defined as a sequence in which the suction motor is turned off, the battery is charged, and then the suction motor is turned on, and when a state in which the battery has not been replaced exceeds a preset number of cycles.

Further, the present disclosure may include a monitoring step of monitoring a voltage of a battery, and a determining step of determining whether the battery has been replaced on the basis of a voltage change of the battery within a preset time.

The determining step may determine that the battery has been replaced when the voltage of the battery changes beyond a preset first range within a preset first time.

The determining step may determine that the battery has not been replaced when the voltage of the battery changes within a first range within a first time.

Further, the present disclosure may further include an outputting step of outputting a signal enabling a user to recognize whether the battery has been replaced.

The outputting step may display, on an output unit, a signal enabling a user to recognize that the battery has not been replaced, when a state in which the battery has not been replaced is maintained for a second time longer than the first time.

The outputting step may display, on a terminal, a signal enabling a user to recognize that the battery has not been replaced, when a state in which the battery has not been replaced is maintained for a second time longer than the first time.

Further, the present disclosure may include a monitoring step of monitoring a voltage of a battery, a sensing step of sensing turning on and turning off of a suction motor that is operated by power of the battery, and a determining step of determining whether the battery has been replaced on the basis of a voltage difference between an off voltage of the battery at a time point at which the suction motor is turned off and an on voltage of the battery at a time point at which the suction motor is turned on.

Further, the present disclosure may further include an outputting step of outputting a signal enabling a user to recognize that the battery has not been replaced, when one cycle is defined as a sequence in which the suction motor is turned off and then turned on again, and when a state in which the battery has not been replaced exceeds a preset number of cycles.

### [Advantageous Effects]

Through the technical solution described above, the present disclosure determines that a battery has been replaced when a variation amount in the voltage of the battery during a predetermined time exceeds a preset reference by monitoring the voltage of a battery over a predetermined time. Accordingly, the present disclosure has an advantage that it can accurately determine replacement of a battery by sensing only the voltage of the battery and reduce a control burden.

Further, the present disclosure monitors the voltage of a battery over a predetermined time, and when a variation amount in the voltage of the battery does not exceed a preset reference during the predetermined and the predetermined time elapses, the present disclosure recommends battery replacement to a user through an output unit of a cleaner and/or a terminal and enables the user to recognize that a spare battery is discharged. Accordingly, the present disclosure has an advantage that it can prevent discharge of the spare battery.

Further, the present disclosure monitors the voltage of a battery when a suction motor is turned off and turned on, and accurately determines battery replacement on the basis of a voltage difference at time points at which the suction motor is turned off and turned on. Accordingly, the present disclosure has an advantage that it can accurately determine battery replacement by sensing only the voltage of the battery and reduce a control burden.

Further, when a cycle in which turning off and turning on of a suction motor is repeated in a state in which a voltage difference at off and on of the suction motor does not reach a predetermined reference exceeds a predetermined number of cycles, the present disclosure recommends battery replacement to a user through an output unit of a cleaner and/or a terminal and enables the user to recognize that a spare battery is discharged, thereby having an advantage that it can prevent discharge of the spare battery, and accurately inform of a timing for battery replacement even when the cleaner is completely discharged and a timer does not operate.

### [Description of Drawings]

FIG. 1 is a side elevational view showing a usage state of a cleaner 1 according to an embodiment of the present disclosure.
FIG. 2 is a perspective view of the cleaner 1 shown in FIG. 1 with a nozzle module 70 detached.
FIG. 3 is a side elevational view of the cleaner 1 shown in FIG. 2.
FIG. 4 is a top elevational view of the cleaner 1 shown in FIG. 2.
FIG. 5 is a cross-sectional view of the cleaner 1 of FIG. 3 taken horizontally along line S1-S1'.
FIG. 6 is a cross-sectional view of the cleaner 1 of FIG. 4 taken vertically along line S2-S2'.
FIG. 7 is a block diagram showing exemplary components of a cleaner according to an embodiment of the present disclosure.
FIG. 8 is a flowchart showing a control method of a cleaner according to an embodiment of the present disclosure.
FIG. 9 is a diagram showing the voltage of a battery over time according to an embodiment of the present disclosure.
FIG. 10 is a diagram showing the voltage of a battery over time according to an embodiment of the present disclosure.
FIG. 11 is a flowchart showing a control method of a cleaner according to another embodiment of the present disclosure.
FIG. 12 is a diagram showing the voltage of a battery over time according to another embodiment of the present disclosure.
FIG. 13 is a diagram showing the voltage of a battery over time according to another embodiment of the present disclosure.

### [Mode for Invention]

For describing the present disclosure, the following description is made based on a three-dimensional orthogonal coordinate system defined by mutually orthogonal X-, Y-, and Z-axes. Each axial direction (X-axis direction, Y-axis direction, and Z-axis direction) refers both directions in which each axis extends. An axial direction preceded by a '+' sign (+X-axis direction, +Y-axis direction, and +Z-axis direction) refers to a positive direction, which is one of the two directions in which each axis extends. An axial direction preceded by a '-' sign (-X-axis direction, -Y-axis direction, and -Z-axis direction) refers to a negative direction, which is the other of the two directions in which each axis extends.

Expressions referring to directions such as "front (+X)/rear (-X)/left (+Y)/right (-Y)/upper (+Z)/lower (-Z)" mentioned below are defined based on the XYZ coordinate axes; however, these definitions are provided solely for clear understanding of the present disclosure, and the respective directions may be defined differently depending on where a reference is set.

The use of terms in which expressions such as "first," "second," and "third" are attached to components mentioned below is solely intended to avoid confusion in identifying the components, and is not related to an order, importance, or a hierarchical relationship among the components. For example, an invention that includes only a second component without a first component may also be implemented.

Singular forms that are used in this specification are intended to include plural forms unless the context clearly indicates otherwise.

A cleaner according to the present disclosure may be a manual cleaner or a robot cleaner. That is, in a manual cleaner represented by a handheld type, a canister type, or an upright type, and in a robot cleaner capable of autonomously traveling in a cleaning space, if a flow path identical or similar to that of the present disclosure is included, application of the invention defined in the claims of the present disclosure is possible.

Hereinafter, a cleaner 1 according to an embodiment of the present disclosure is described as being limited to a handheld manual cleaner.

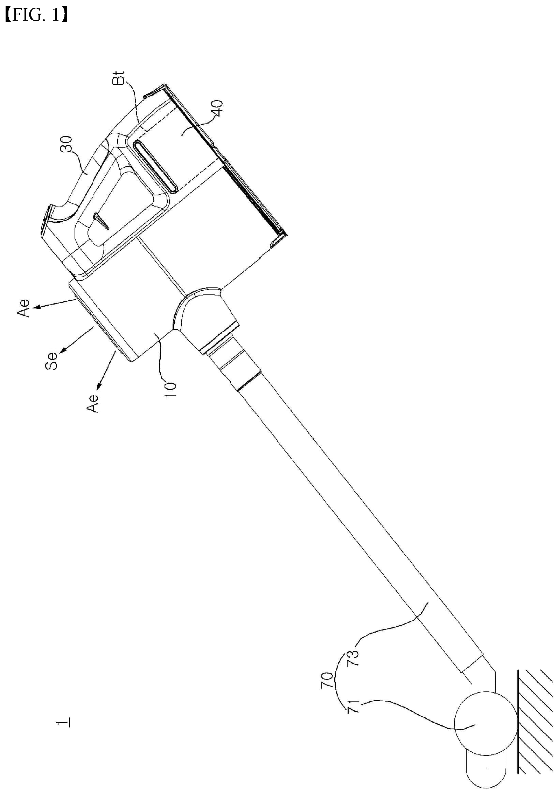

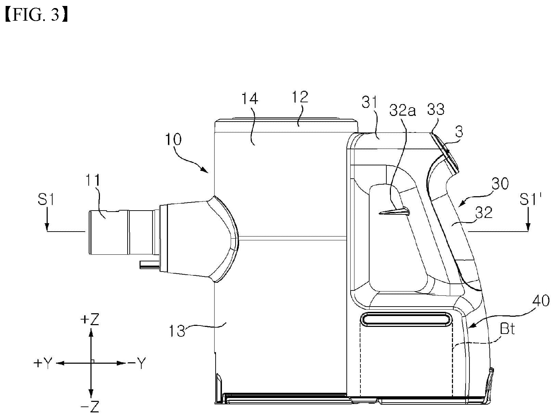

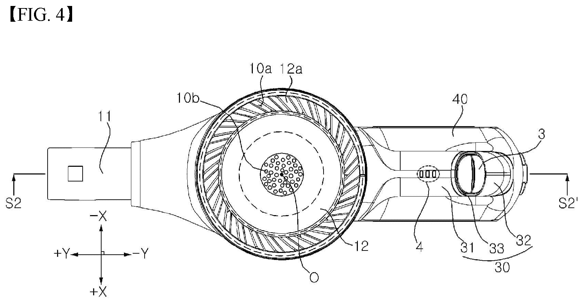

Referring to FIGS. 1 to 6, a cleaner 1 according to an embodiment includes a main body 10 that forms a flow path P for guiding suctioned air to be discharged to the outside. The cleaner 1 includes a dust separation unit 20 disposed in the flow path P and separating dust in the air. The cleaner 1 includes a handle 30 coupled to one side of the main body 10.

The cleaner 1 may include a battery Bt that supplies power and a battery housing 40 in which the battery Bt is accommodated. The cleaner 1 includes a fan module 50, 50' disposed in the flow path P and moving air in the flow path P. The cleaner 1 includes filters 61, 62 disposed in a flow path P and separating dust in air, in addition to the dust separation unit 20.

The cleaner 1 includes a nozzle module 70 detachably connected to a suction pipe 11 of a main body 10. The cleaner 1 includes an input unit 3 through which a user can input On/Off or a suction mode of the cleaner 1, and an output unit 4 that displays various states of the cleaner 1 to the user.

Meanwhile, a noise control module 80, 80', 180, 280, 380, 980 that performs at least one of i) a first function that reduces the magnitude of noise in a relatively low-frequency band within an audible frequency band and ii) a second function that increases the magnitude of noise in a relatively high-frequency band within an audible frequency band may be provided at a discharge port of the cleaner 1. The noise control module includes a speaker 89, 989 that outputs sound. According to an embodiment, the cleaner 1 may further include a sound transmission pipe 90 that transmits sound of the speaker 89, 989 to a sound outlet 10b, 10b'.

Referring to FIG. 1, the nozzle module 70 includes a suction nozzle 71 provided to suction external air and an extension pipe 73 extending longitudinally from the suction nozzle 71. The extension pipe 73 connects the suction nozzle 71 and the suction pipe 11. The extension pipe 73 guides air suctioned from the suction nozzle 71 such that the air flows into a suction flow path P1. One end of the extension pipe 73 may be detachably coupled to the suction pipe 11 of the main body 10. A user can clean while holding the handle 30 and moving the suction nozzle 71 with the suction nozzle 71 on a floor.

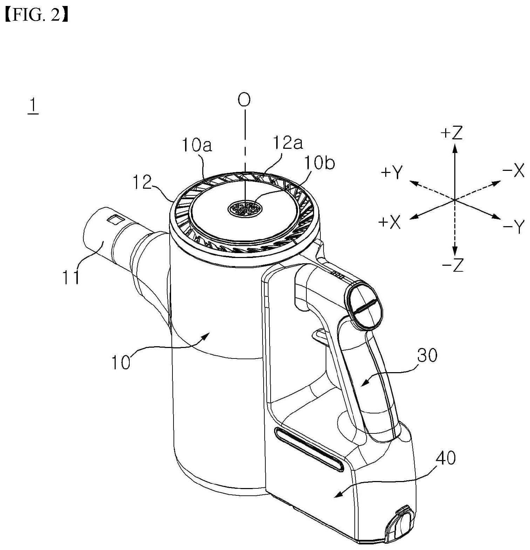

Referring to FIGS. 2 to 6, the main body 10 forms the external appearance of the cleaner 1. The main body 10 may be formed in a vertically elongated cylindrical shape as a whole. The dust separation unit 20 is accommodated in the main body 10. The fan module 50, 50' is accommodated in the main body 10. The main body 10 includes a suction pipe 11 that guides suction of air into the main body 10. The suction pipe 11 forms a suction flow path P1. The suction pipe 11 may protrude forward from the main body 10. Further, a handle 30 is coupled in a direction opposite to the suction pipe 11 with the main body 10 therebetween. Further, the battery Bt for supplying power to the fan module 50, 50' may be mounted under the handle 30.

The main body 10 includes a discharge cover 12, 12' that forms an exhaust port 10a, 10a'. The discharge cover 12, 12' may form the upper surface of the main body 10. The discharge cover 12, 12' covers the upper portion of a fan module housing 14.

The main body 10 includes a dust collection unit 13 for storing dust separated by the dust separation unit 20. At least a portion of the dust separation unit 20 may be disposed in the dust collection unit 13. The inner surface of the upper portion of the dust collection unit 13 can perform the function of a first cyclone portion 21 to be described later (in this case, the upper portion of the dust collection unit 13 may be referred to as the first cyclone portion 21. A second cyclone portion 22 and a dust flow guide 24 are disposed in the dust collection unit 13.

The dust collection unit 13 may be formed in a cylindrical shape. The dust collection unit 13 is disposed under the fan module housing 14. Dust storage spaces S1, S2 are formed in the dust collection unit 13. A first storage space S1 is formed between the dust collection unit 13 and the dust flow guide 24. A second storage space S2 is formed in the dust flow guide 24.

The main body 10 includes the fan module housing 14 that accommodates the fan module 50, 50' therein. The fan module housing 14 may be formed to extend upward from the dust collection unit 13. The fan module housing 14 is formed in a cylindrical shape. An extension 31 of the handle 30 is disposed at a side opposite to the suction pipe 11 with the fan module housing 14 therebetween.

The main body 10 includes a dust cover 15 provided to open and close the dust collection unit 13. The dust cover 15 may be rotatably coupled to the bottom side of the dust collection unit 13. The dust cover 15 can open and close the bottom side of the dust collection unit 13 by rotating. The dust cover 15 may include a hinge (not shown) for rotation. The hinge may be coupled to the dust collection unit 13. The dust cover 15 can open and close the first storage space S1 and the second storage space S2 together.

The main body 10 includes an air guide 16 that guides air discharged from the dust separation unit 20. The air guide 16 forms a fan module flow path P4, P4' that guides air from the dust separation unit 20 to the impeller 52. The air guide 16 includes an exhaust flow path P5, P5' that guides air that has passed through the impeller 52 to the exhaust port 10a, 10a'. The air guide 16 may be disposed in the fan module housing 14.

Meanwhile, the fan module 50 may be composed of an impeller 52, a suction motor 51 for operating the impeller 52, and a shaft 53 for coupling the suction motor 51 and the impeller 52. The direction of a flow path for suction into the fan module 50 is determined on accordance with the disposition position and direction of the impeller 52 in the fan module 50.

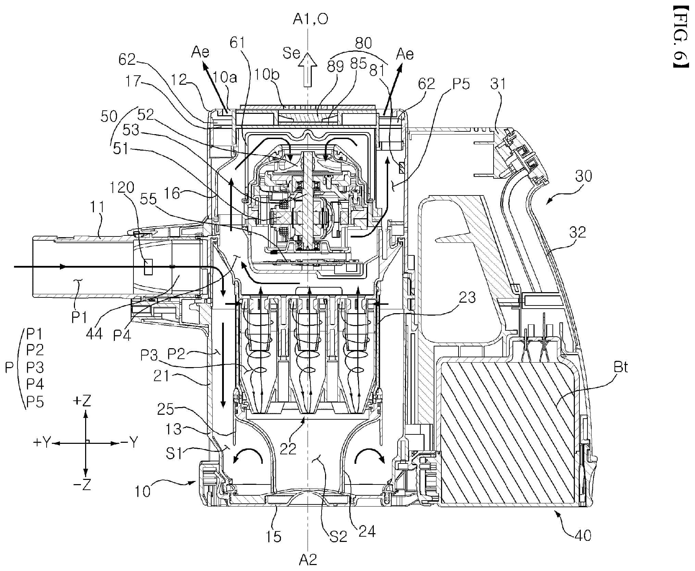

As an example, referring to FIGS. 6a to 6c, when an inlet of the impeller 52 is installed in a direction opposite to the suction motor 51 over the suction motor 51, flow paths P4 and P5 may be formed such that air discharged from the dust separation unit 20 rises, descends while passing through the impeller 52, and then rises again to the exhaust port 10a, 10a'.

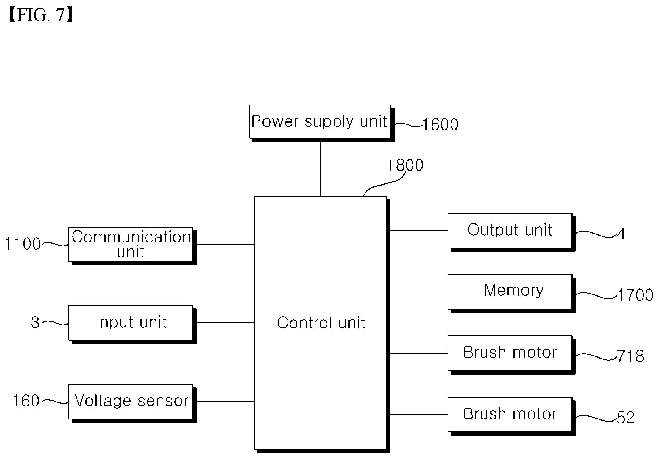

As another example, referring to FIG. 7, when the inlet of the impeller 52 is installed in a direction opposite to the suction motor 51 under the suction motor 51, flow paths P4 and P5 may be formed such that air discharged from the dust separation unit 20 continuously rises to the exhaust port 10a, 10a' while passing through the impeller 52.

Further, when the inlet of the impeller 52 is installed to face the motor, in the embodiment of FIG. 7, the impeller 52 may be installed over the suction motor 51.

Referring to FIGS. 2, 4, and 6, the main body 10 forms the exhaust port 10a, 10a' through which air in the flow path P is discharged to the outside of the main body 10. The exhaust port 10a, 10a' may be formed in the discharge cover 12, 12'.

The exhaust port 10a, 10a' may be disposed on one surface of the main body 10. The exhaust port 10a, 10a' may be formed on the upper surface of the main body 10. Accordingly, scattering of dust around the cleaner due to air discharged from the exhaust port 10a, 10a' is prevented, and the phenomenon in which air discharged from the exhaust port 10a, 10a' directly impinges on a user can be prevented. Further, the sound outlet may be disposed on the same surface, among the surfaces of the main body 10, as the surface on which the exhaust port 10a, 10a' is formed.

The exhaust port 10a, 10a' may be disposed to face a specific direction (for example, the upward direction). The discharge direction Ae of air discharged through the exhaust port 10a, 10a' may be a specific direction.

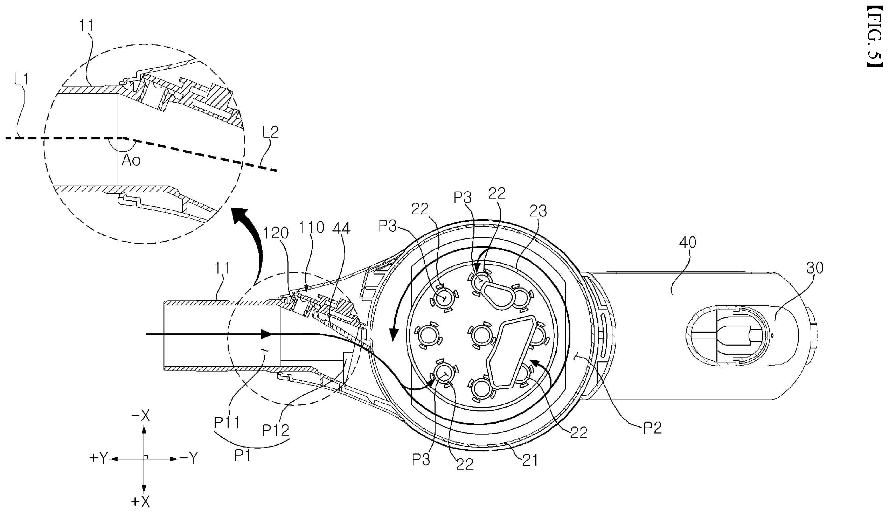

Referring to FIGS. 5 to 6, the dust separation unit 20 performs a function of filtering out dust in the flow path P. The dust separation unit 20 separates dust suctioned into the main body 10 through the suction pipe 11 from air.

As an example, the dust separation unit 20 may include a first cyclone portion 21 and a second cyclone portion 22 that can separate dust by cyclone flow. A flow path P2 formed by the first cyclone portion 21 may be connected with the suction flow path P1 formed by the suction pipe 11. Air and dust that are suctioned through the suction pipe 11 spirally flow in along the inner circumferential surface of the first cyclone portion 21.

An axis A2 of the cyclone flow in the first cyclone portion 21 may extend in the vertical direction. The axis A2 of the cyclone flow may coincide with an axis O. The second cyclone portion 22 separates dust additionally from the air that has passed through the first cyclone portion 21. The second cyclone portion 22 may be positioned in the first cyclone portion 21. The second cyclone portion 22 may be positioned inside a boundary portion 23. The second cyclone portion 22 may include multiple cyclone bodies arranged in parallel.

As another example, the dust separation unit 20 may have a single cyclone portion. Even in this case, the axis A2 of the cyclone flow may extend in the vertical direction.

As another example, the dust separation unit 20 may include a main filter unit instead of a cyclone portion. The main filter unit can separate dust from air that is introduced from the suction pipe 11.

Hereinafter, the dust separation unit 20 is described based on this embodiment including the first cyclone portion 110 and the second cyclone portion 130, but it is not necessarily limited thereto

The dust separation unit 20 forms dust separation flow paths P2 and P3. As air moves at a high speed through the dust separation flow paths P2 and P3, dust in the air is separated, and the separated dust is stored in a first storage space S1.

The space between the inner circumferential surface of the first cyclone portion 21 and the outer circumferential surface of the boundary portion 23 becomes a first cyclone flow path P2. Air that has passed through the suction flow path P1 spirally moves downward in the first cyclone flow path P2, and dust in the air is centrifugally separated. Here, an axis A2 becomes the axis A2 of the downward spiral flow.

The dust separation unit 20 includes the boundary portion 23 cylindrically disposed in the first cyclone portion 21. The boundary portion 23 forms a plurality of holes on an outer circumferential surface. Air in the first cyclone flow path P2 can pass through the plurality of holes of the boundary portion 23 and be introduced into the second cyclone flow path P3. Large-volume dust may be filtered out by the plurality of holes of the boundary portion 23.

The upper portion of the second cyclone portion 22 is disposed in the boundary portion 23. The second cyclone portion 22 includes a plurality of cyclone bodies that are hollow inside and have a vertical through-passage. Each cyclone body may be formed in a pipe shape that becomes narrower toward the bottom side. A second cyclone flow path P3 is formed in each cyclone body. Air that has passed through the boundary portion 23 moves to the second cyclone flow path P3 along a guide that is disposed at the upper portion of the cyclone body and guides air flow spirally downward. When air moves spirally downward along the inner circumferential surface of the cyclone body, dust in the air is centrifugally separated and the separated air is stored in the second storage space S2. Air that has moved to the lower portion of the cyclone body along the second cyclone flow path P3 moves upward along a vertical central axis of the second cyclone flow path P3 and is introduced into the fan module flow path P4, P4'.

The dust separation unit 20 includes a dust flow guide 24 that separates the first storage space S1 and the second storage space S2 in the dust collection unit 13. The space between the dust flow guide 24 and the inner surface of the dust collection unit 13 is the first storage space S1. The internal space of the dust flow guide 24 is the second storage space S2.

The dust flow guide 24 is coupled to the bottom side of the second cyclone portion 22. The dust flow guide 24 is in contact with the upper surface of the dust cover 15. A portion of the dust flow guide 24 may be formed such that the diameter thereof decreases toward the bottom side from the top side. As an example, the upper portion of the dust flow guide 24 may be formed such that the diameter thereof decreases toward the bottom side, and the lower portion of the dust flow guide 24 may be formed in a cylindrical shape extending vertically.

The dust separation unit 20 may include an anti-scattering rib 25 that extends downward from the upper end of the dust flow guide 24. The anti-scattering rib 25 can surround the circumference of the upper portion of the dust flow guide 24. The anti-scattering rib 25 may circumferentially extend around an axis A2 of flow. As an example, the anti-scattering rib 25 may be formed in a cylindrical shape.

When the upper portion of the dust flow guide 24 is formed such that the diameter thereof decreases toward the bottom side, a space is formed between the outer circumferential surface of the upper portion of the dust flow guide 24 and the anti-scattering rib 25. When upward air flow occurs along the dust flow guide 24 in the first storage space S1, rising dust is trapped by the space between the anti-scattering rib 25 and the upper portion of the dust flow guide 24. Accordingly, dust in the first storage space S1 can be prevented from flowing upward in a reverse direction.

The handle 30 is coupled to the main body 10. The handle 30 may be coupled in a direction opposite to the suction pipe 11 with the main body 10 therebetween. The handle 30 may be coupled to the upper side of the battery housing 40.

The handle 30 includes an extension 31 that protrudes and extends rearward from the main body 10. The extension 31 may extend forward from the upper portion of an additional extension 32. The extension 31 may extend in the horizontal direction. In an embodiment B to be described later, a speaker 989 is disposed in the extension 31.

The handle 30 extends in the vertical direction and includes an additional extension 32. The additional extension 32 may be spaced apart from the main body 10 in the front-rear direction. A user can use the vacuum cleaner 1 in a state in which the user grips the additional extension 32. The upper end of the additional extension 32 is connected to the rear end of the extension 31. The lower end of the additional extension 32 is connected to the battery housing 40.

The additional extension 32 may have a movement restriction portion 32a for preventing a user's hand from moving in the longitudinal direction of the additional extension 32 (in the vertical direction) in a state in which the user grips the additional extension 32. The movement restriction portion 32a may protrude forward from the additional extension 32.

The movement restriction portion 32a is disposed to be spaced apart from the extension 31 in the vertical direction. In a state in which a user grips the additional extension 32, some fingers of the user's gripping hand are positioned over the movement restriction portion 32a, and remaining fingers are positioned under the movement restriction portion 32a.

The handle 30 may include an inclined surface 33 facing a direction between the top side and the rear side. The inclined surface 33 may be positioned on the rear surface of the extension 31. The input unit 3 may be disposed on the inclined surface 33.

The battery Bt can supply power to the fan module 50, 50'. The battery Bt can supply power to the noise control module. The battery Bt may be detachably disposed in the battery housing 40.

The battery housing 40 is coupled to the rear side of the main body 10. The battery housing 40 is disposed under the handle 30. The battery Bt is accommodated in the battery housing 40. Heat dissipation holes for discharging heat generated by the battery Bt to the outside may be formed in the battery housing 40.

Referring to FIG. 6, the cleaner 1 may include a pre-filter 61 that filters air before the air is suctioned into the suction motor 51. The pre-filter 61 may be disposed to surround the impeller 52. Air in the fan module flow path P4, P4' passes through the pre-filter 61 and reaches the impeller 52. The pre-filter 61 is disposed in the main body 10. The pre-filter 61 is disposed under the discharge cover 12, 12'. By separating the discharge cover 12, 12' from the cleaner 1, a user can take the pre-filter 61 out of the main body 10.

Referring to FIG. 6, the cleaner 1 may include a HEPA filter 62 that filters air before the air is discharged through the exhaust port 10a, 10a'. Air that has passed through the impeller 52, 52' passes through the HEPA filter 62 and then can be discharged to the outside through the exhaust port 10a. The HEPA filter 62 is disposed in the exhaust flow path P5.

The discharge cover 12, 12' may form a filter accommodation space for accommodating the HEPA filter 62. The filter accommodation space is formed to be open at the bottom side thereof, and the HEPA filter 62 can be accommodated in the filter accommodation space under the discharge cover 12, 12'.

The exhaust port 10a may be formed to face the HEPA filter 62. The HEPA filter 62 is disposed under the exhaust port 10a, 10a'. The HEPA filter 62 may be disposed to extend circumferentially along the exhaust port 10a, 10a'.

The main body 10 includes a filter cover 17 that covers the bottom surface of the HEPA filter 62. In a state in which the HEPA filter 62 is accommodated in the filter accommodation space, the bottom side of the HEPA filter 62 is covered by the filter cover 17, and a hole through which air in the exhaust flow path P5 passes is formed in the filter cover 17. The filter cover 17 may be detachably coupled to the discharge cover 12, 12'.

The discharge cover 12, 12' may be detachably coupled to the fan module housing 14. When the filter cover 17 is separated from the discharge cover 12, 12' separated from the fan module housing 14, the HEPA filter 62 can be taken out of the filter accommodation space.

Although the cleaner 1 has been described as including the pre-filter 61 and the HEPA filter 62 in the present disclosure, the type and number of filters are not limited.

Meanwhile, the input unit 3 may be positioned at a side opposite to the movement restriction portion 32a with the handle 30 therebetween. The input unit 3 may be disposed on the inclined surface 33.

Further, the output unit 4 may be disposed at the extension 31. As an example, the output unit 4 may be positioned on the upper surface of the extension 31. The output unit 4 may include a plurality of transmitters 111. The plurality of transmitters 111 may be spaced apart from each other and arranged in the longitudinal direction (front-rear direction) of the extension 31.

Meanwhile, referring to FIGS. 5 to 6, the flow path P is formed by sequentially connecting the suction flow path P1, the dust separation flow paths P2 and P3, the fan module flow path P4, P4', and the exhaust flow path P5, P5'.

In particular, referring to FIG. 5, the suction flow path P1 provides external air to the dust separation unit 20. The suction flow path P1 is connected with the dust separation unit 20. Specifically, the suction flow path P1 may be defined by the suction pipe 11, a portion of the suction flow path P1 may be exposed to an outside of the main body 10, and the other side of the suction flow path P1 may be positioned in the main body 10. One side of the suction flow path P1 may be coupled to the extension pipe 73 connected with the suction nozzle 71. Air in the suction flow path P1 is moved by the fan module.

The suction flow path may include a first suction flow path P11 extending in a first direction, and a second suction flow path P12 connecting the first suction flow path P11 and the dust separation unit 20 and extending in a second direction forming an obtuse angle with the first direction.

The first suction flow path P11 may have a linear shape extending in the first direction. Specifically, the suction pipe 11 defining the first suction flow path P11 may be a pipe having a linear shape extending in the first direction. At least a portion of the first suction flow path P11 is exposed to the outside of the main body 10. An extension line of the first direction meets a rotation axis of the fan module (the axis A2 of cyclone flow).

One end of the second suction flow path P12 is connected with the first suction flow path P11, and the other end is connected with the dust separation unit 20. The second suction flow path P12 communicates with the dust separation flow path P2 of the dust separation unit 20. The second suction flow path P12 is positioned in the main body 10.

The second suction flow path P12 changes the direction of air that is introduced into the dust separation unit 20 such that the air exhibits a cyclone motion about the axis A2 of cyclone flow, and reduces the flow speed of the air that is introduced.

Specifically, the second suction flow path P12 may extend in a second direction L2 forming an obtuse angle with a first direction L1. The second suction flow path P12 may form a straight line or a curve. The angle A0 formed between the first suction flow path P11 and the second suction flow path P12 is preferably in a range of 150 degrees to 170 degrees. The first direction is the front-rear direction, and the angle A0 formed by the first suction flow path P11 and the second suction flow path P12 is an angle measured on a front-rear and left-right plane.

The first suction flow path P11 is a passage for introducing dust and air suctioned from a suction nozzle 71 into the dust separation unit 20. Air moving in the first suction flow path P11 should maintain a flow speed such that dust and air do not flow backward during movement.

The first suction flow path P11 may be defined as a region in the suction pipe 11 in which a flow speed is highest. Further, the first suction flow path P11 may be defined as a region in the suction pipe 11 in which a flow speed is relatively higher than that in other regions.

The second suction flow path P12, which forms a primary cyclone inlet through a flip door 44 and the outer wall of the suction pipe 11 at an end of the first suction flow path P11, may be defined as a region in the suction pipe 11 in which a flow speed is lower than that in the first suction flow path P11.

The flap door 44 for opening and closing the suction pipe 11 is installed in the suction pipe 11. The flap door 44 is rotatably installed in the second suction flow path P12 and opens and closes the suction flow path, depending on the pressure in the second suction flow path P12.

Air and dust suctioned through the suction flow path P1 by operation of the suction motor 51 are separated from each other while flowing in the first flow path P2 and the second cyclone flow path P3. In the second cyclone flow path P3, air, as described above, moves upward and flows into the fan module flow path P4, P4'.

The fan module flow path P4, P4' guides air toward the pre-filter 61. Air that has sequentially passed through the pre-filter 61 and the impeller 52 flows into the exhaust flow path P5, P5'. Air in the exhaust flow path P5, P5' is discharged to the outside through the exhaust port 10a, 10a' after passing through the HEPA filter 62.

As an example, referring to FIG. 6, the fan module flow path P4 guides air such that air discharged from the dust separation unit 20 rises and then descends while passing through the impeller 52. Here, the exhaust flow path P5 guides air such that air that has descended while passing through the impeller 52 rises again up to the exhaust port 10a, 10a'.

The present disclosure may be equipped with a dust sensor 110. The dust sensor 110 measures the concentration of dust in the suction flow path.

Further, the present disclosure may further include a voltage sensor 160. The voltage sensor 160 measures the voltage of a battery and provides the measured voltage to a control unit. The voltage sensor 160 measures a discharging voltage of a battery when the suction motor is operating and measures a charging voltage when the battery is being charged.

Hereinafter, an embodiment related to control components of the cleaner 1 is described with reference to FIG. 7.

Referring to FIG. 7, the cleaner 1 according to an embodiment of the present disclosure may include at least one of, or a combination of, a communication unit 1100, an input unit 3, an output unit 4, a power supply unit 1600, a memory 1700, a control unit 1800, a voltage sensor 160, a brush motor 718, and a suction motor 51.

In this case, the components shown in FIG. 7 are not essential, and a cleaner having more components or fewer components may also be implemented.

Hereinafter, the components are described. First, the power supply unit 1600 includes a battery rechargeable by an external commercial power source and supplies power into the cleaner. The power supply unit 1600 can supply operating power required for the cleaner to travel or perform a specific function by supplying driving power to the components included in the cleaner.

In this case, the control unit 1800 senses a remaining power level of the battery and can charge the battery by receiving a charging current from a charging stand. The battery is connected with a battery sensing unit, so the remaining battery level and the charging state can be transmitted to the control unit 1800. The output unit 4 can display a remaining battery level on the output unit 4 under control of the control unit 1800.

The control unit 1800, which processes information on the basis of artificial intelligence technology, may include at least one or more modules that perform at least one of information learning, information inference, information perception, and natural language processing.

The control unit 1800 can perform at least one of learning, inferring, and processing of a large amount of information (big data) such as information stored in the cleaner, environmental information around a mobile terminal, and information stored in a communicable external storage, using machine learning technology.

Further, the control unit 1800 can predict (or infer) at least one executable operation of the cleaner using information learned using machine learning technology, and can control the cleaner such that an operation having the highest feasibility among the at least one predicted operation is executed. Machine learning technology is a technology that collects and learns large-scale information on the basis of at least one algorithm and determines and predicts information on the basis of the learned information.

Learning information is an operation that quantifies relationships between information and information by identifying characteristics, rules, and determination criteria of information and predicting new data using quantified patterns.

Further, the control unit 1800 outputs information provided from sensors included in the cleaner through the output unit 4.

Meanwhile, the input unit 3 receives various control commands for the cleaner from a user. The input unit 3 may include one or more buttons.

Further, the input unit 3 may be installed on the upper portion of the main body 10 in the form of a hard key, a soft key, a touch pad, or the like. Further, the input unit 3 may be implemented in the form of a touch screen together with the output unit 4. The input unit 3 can receive a control command for the brush motor 718 and/or a control command for the suction motor 51 from a user.

Meanwhile, the output unit 4 may be installed on the upper portion of the cleaner. Of course, the installation position or the installation form may vary. For example, the output unit 4 can display, on a screen, the battery state, the state of the brush motor 718, the state of the suction motor 51, the current state of the suction nozzle 71, and the like.

The output unit 4 may be formed as any one of a light emitting diode (LED), a liquid crystal display (LCD), a plasma display panel, and an organic light emitting diode (OLED).

The output unit 4 may further include an audio output unit that audibly outputs an operation process or an operation result of the cleaner performed by the control unit 1800. For example, the output unit 4 can output a warning sound to the outside in accordance with a warning signal generated by the control unit 1800.

In this case, the audio output unit (not shown) may be a unit that outputs sound such as a beeper or a speaker, and the output unit 4 can output sound to the outside through the audio output unit using audio data or message data having a predetermined pattern stored in the memory 1700.

The memory 1700 stores a control program for controlling or driving the cleaner and data corresponding thereto. The memory 1700 can store audio information, video information, obstacle information, location information, map information, and the like. Further, the memory 1700 can store information related to a traveling pattern.

The memory 1700 mainly uses a non-volatile memory. Here, Non-Volatile Memory (NVM) (NVRAM) is a storage device capable of continuously retaining stored information even when power is not supplied, and may be, for example, ROM, flash memory, a magnetic computer storage device (for example, a hard disk, a diskette drive, or magnetic tape), an optical disk drive, magnetic RAM, PRAM, or the like.

Meanwhile, the communication unit 1100 is connected with a terminal device and/or another device (for example, a terminal) located within a specific area by one of wired, wireless, and satellite communication schemes, and transmits and receives signals and data.

The communication unit 1100 can transmit and receive data with another device located within a specific area. In this case, the other device may be any device capable of transmitting and receiving data by connecting to a network, and may be, for example, devices such as an air conditioning device, a heating device, an air purification device, a lamp, a television, and a vehicle. Further, the other device may be a device that controls a door, a window, a water valve, a gas valve, or the like. Further, the other device may be a sensor that senses temperature, humidity, atmospheric pressure, gas, or the like.

The brush motor 718 provides rotational force to the brush 712, thereby rotating the brush 712.

The control unit 1800 can determine whether the battery Bt needs to be replaced based on a voltage change and/or a voltage value provided from the voltage sensor 160.

A voltage when the battery Bt supplies power to the suction motor 51 or another component is defined as a discharging voltage, and the discharging voltage of the battery Bt gradually decreases as the number of uses of the battery Bt increases. The discharging voltage of the battery Bt may also be referred to as a voltage of the battery Bt.

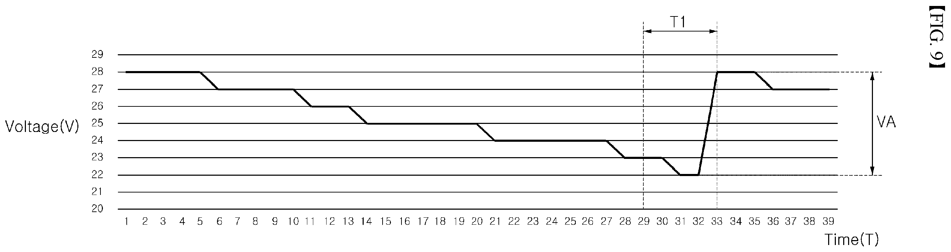

Referring to FIG. 9, the voltage of the battery Bt decreases as time elapses with use, and the voltage changes significantly when the battery Bt is replaced. Therefore, when a variation amount VA during a first time T1 exceeds a preset criterion, it is determined that the battery Bt has been replaced.

For example, when the voltage of the battery Bt changes beyond a preset first range within a preset first time T1, the control unit 1800 determines that the battery Bt has been replaced. Further, when the control unit 1800 determines that the battery Bt has been replaced, the control unit 1800 can output a control command to cause the output unit 4 to display a signal enabling a user to recognize replacement of the battery Bt. For example, when the control unit 1800 determines that the battery Bt has been replaced, the control unit 1800 can output a message or an image indicating that the battery Bt has been replaced on the output unit 4. Here, the first range may be set to 4 V to 7 V.

When the voltage of the battery Bt (VA) changes within the preset first range within the preset first time T1, the control unit 1800 determines that the battery Bt has not been replaced.

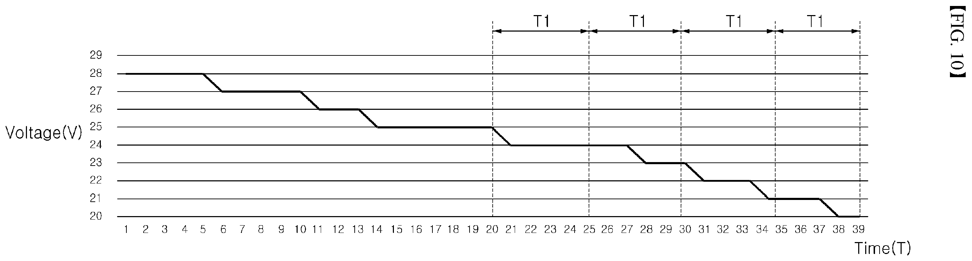

Referring to FIG. 10, the voltage of the battery Bt decreases as time elapses with use, and continuously decreases when the battery Bt is not replaced.

When a state in which the battery Bt has not been replaced is maintained for a second time longer than the first time T1, the control unit 1800 can output a control command to cause the output unit 4 to display a signal enabling a user to recognize that the battery Bt has not been replaced. Specifically, when a state in which the battery Bt has not been replaced is maintained for the second time longer than the first time T1, the control unit 1800 can control the output unit 4 to output a message or an image indicating that a spare battery Bt may be discharged because the battery Bt has not been replaced.

Therefore, in the present disclosure, when a state in which the battery Bt has not been replaced is maintained for the second time longer than the first time T1, it is possible to warn a user of discharge of the spare battery Bt, and even when only one voltage sensor 160 is used, since only a voltage variation amount needs to be calculated for each unit time regardless of other variables, a control burden is reduced and there is an advantage that it is not necessary to consider other operations even when other operations occur between unit times.

Further, the voltage of the battery Bt may be a corrected value calibrated in accordance with a usage state of the cleaner. For example, as a rotational speed of the suction motor 51 increases, a measured voltage of the battery Bt can be multiplied by a smaller correction value.

For example, the modes of the suction motor 51 may be classified into a weak mode, a strong mode, and a turbo mode in an order in which the rotational speed of the suction motor 51 increases. When the voltage of the battery Bt is obtained by multiplying a measured voltage of the battery Bt by a correction value of 0.6 in the turbo mode, the voltage of the battery Bt may be obtained by multiplying a measured voltage of the battery Bt by a correction value of 1 in the weak mode, and the voltage of the battery Bt may be obtained by multiplying a measured voltage of the battery Bt by a correction value of 0.8 in the strong mode.

Here, the first time T1 may be set to 30 minutes to 1 hour, and the control unit 1800 can determine, at intervals of 1 minute to 5 minutes, as a voltage variation amount during the first time T1 prior to a current time.

The second time may be set to time sufficiently longer than the first time T1. Preferably, the second time may be 40 days to 60 days.

The cleaner of the present disclosure is connected with a terminal (not shown) through a communication method. When a state in which the battery Bt has not been replaced is maintained for the second time longer than the first time T1, the control unit 1800 can output a control command to cause the output unit 4 to display a signal or an alarm enabling a user to recognize that the battery Bt has not been replaced.

That is, when the battery Bt has not been replaced for an extended period, the control unit 1800 can output a message warning that the spare battery Bt may be discharged to a terminal connected to the cleaner.

Of course, a user may turn off or turn on such an alarm for the battery Bt through the input unit of the cleaner or the terminal.

As another example, when a voltage difference VD between an off voltage of the battery Bt at the time point at which the suction motor 51 is turned off and an on voltage of the battery Bt at the time point at which the suction motor 51 is turned on again after being turned off exceeds a first voltage difference, the control unit 1800 can determine that the battery Bt has been replaced. The voltage difference VD is preferably set to 4 V to 7 V.

Here, the off voltage of the battery Bt may be the voltage of the battery Bt after a preset time elapses from the time point at which the suction motor 51 is turned off, and the on voltage of the battery Bt may be the voltage of the battery Bt after a preset time elapses from the time point at which the suction motor 51 is turned on.

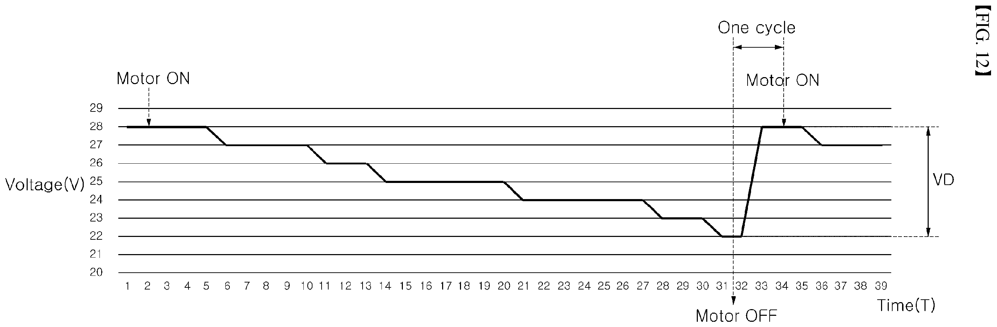

Referring to FIG. 12, when the suction motor 51 is turned on and time elapses, a voltage gradually decreases. When the suction motor 51 is turned off, the battery Bt is replaced, and then the suction motor 51 is turned on, the voltage of the battery Bt suddenly increases. Therefore, when there is an increase or a change in the voltage of the battery Bt, it is determined that replacement of the battery Bt has occurred.

In the present disclosure, since monitoring of the voltage of the battery Bt on a time basis is supplemented and the voltage of the battery Bt is measured in accordance with use of the cleaner, it is possible to accurately determine replacement of the battery Bt.

When the voltage difference VD is smaller than a first voltage difference, the control unit 1800 can determine that the battery Bt has not been replaced.

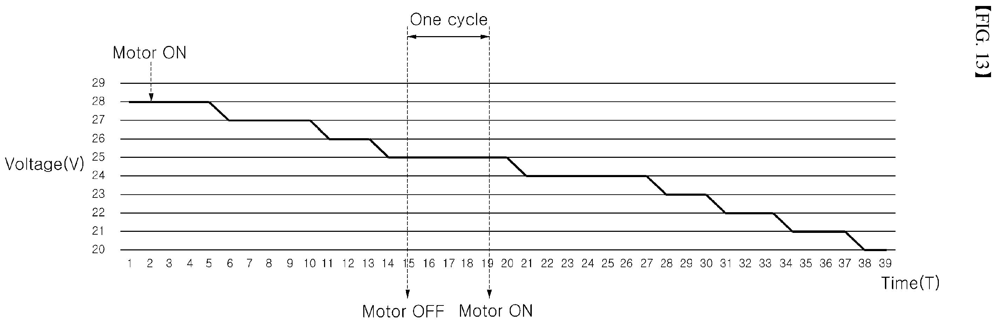

Referring to FIG. 13, when the suction motor 51 is turned on and time elapses, a voltage gradually decreases. Thereafter, when the suction motor 51 is turned off and then turned on, the voltage of the battery Bt becomes similar or slightly decreases. Therefore, when such a fine change occurs in the voltage of the battery Bt, it is determined that replacement of the battery Bt has not occurred.

When one cycle is defined as a sequence in which the suction motor 51 is turned off and then turned on again, and when a state in which the battery Bt has not been replaced exceeds a preset number of cycles, the control unit 1800 can output a control command to cause the output unit 4 to display a signal enabling a user to recognize that the battery Bt has not been replaced.

When one cycle is defined as a sequence in which the suction motor 51 is turned off and then turned on, and the cycle is repeated 60 to 80 times, a recommendation for replacement of the battery Bt can be provided to a user or an alarm indicating discharge of the spare battery Bt can be generated. When such a cycle is used, a timer is not required as in a time-based approach, and there is an advantage of informing of replacement of the battery Bt in accordance with a user's usage pattern of the cleaner.

When a state in which the battery Bt has not been replaced exceeds a preset number of cycles, the control unit 1800 can output a control command to cause a terminal to display a signal enabling a user to recognize that the battery Bt has not been replaced. The preset cycle may be 60 to 80.

As another example, when a voltage difference VD between an off voltage of the battery Bt at a time point at which the suction motor 51 is turned off and an on voltage of the battery Bt at a time point at which the suction motor 51 is turned on after the suction motor 51 is turned off and the battery Bt is charged exceeds a first voltage difference, the control unit 1800 can determine that the battery Bt has been replaced.

When the battery Bt is charged, the voltage of the battery Bt slightly increases. That is, when a slope of a change in the battery Bt is within a preset range, the control unit 1800 can determine charging of the battery Bt.

When one cycle is defined as a sequence in which the suction motor 51 is turned off, the battery Bt is charged, and then the suction motor 51 is turned on, and when a state in which the battery Bt has not been replaced exceeds a preset number of cycles, the control unit 1800 can output a control command to cause the output unit 4 to output a signal enabling a user to recognize that the battery Bt has not been replaced.

Hereinafter, a control method according to an embodiment of the present disclosure is described.

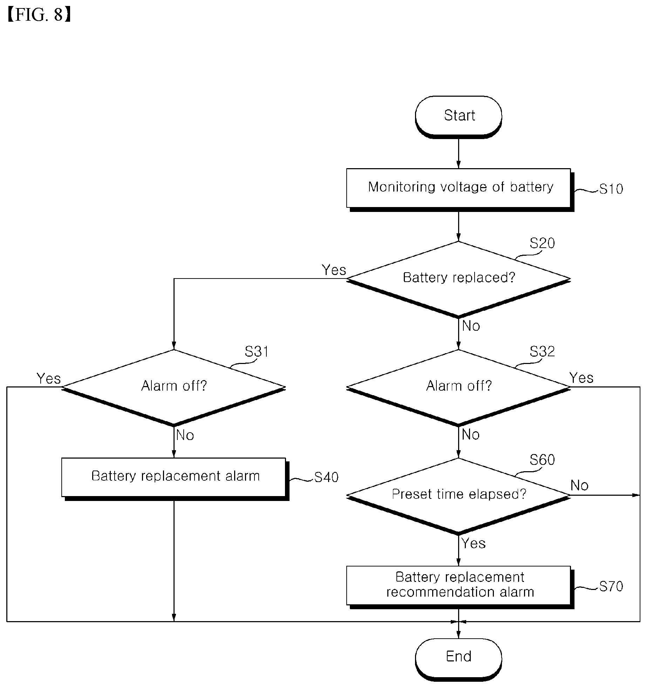

FIG. 8 is a flowchart showing a control method of a cleaner according to an embodiment of the present disclosure.

Referring to FIG. 8, a control method of a cleaner according to an embodiment of the present disclosure includes a monitoring step S10 of monitoring the voltage of a battery Bt and a determining step S20 of determining whether the battery Bt has been replaced on the basis of a voltage change of the battery Bt within a preset time.

The monitoring step S10 monitors the voltage of the battery Bt. Specifically, the voltage sensor 160 measures the voltage of the battery Bt at each preset time and provides the measured voltage to the control unit 1800.

In the determining step S20, the control unit 1800 determines whether the battery Bt has been replaced on the basis of a voltage change of the battery Bt within a preset time. Specifically, in the determining step S20, when the voltage of the battery Bt changes beyond a preset first range within a preset first time T1, it is determined that the battery Bt has been replaced.

In the determining step S20, when the voltage of the battery Bt changes within the preset first range within the preset first time T1, the control unit 1800 determines that the battery Bt has not been replaced.

After the determining step, the control unit 1800 can output a signal enabling a user to recognize whether the battery Bt has been replaced (S40) (S70).

Specifically, in the determining step S20, when it is determined that the battery Bt has been replaced, the control unit 1800 determines whether an alarm is turned off (S31), and when the alarm is not turned off, the control unit 1800 can transmit a message indicating replacement of the battery Bt to the output unit 4 and/or a terminal (S40).

In the determining step S20, when it is determined that the battery Bt has not been replaced, the control unit 1800 determines whether an alarm is turned off (S32), and when the alarm is not turned off, if a preset second time elapses without the battery Bt replaced (S60), the control unit 1800 can output a message recommending replacement of the battery Bt or a message indicating that the spare battery Bt may be discharged through a terminal and/or the output unit 4 (S70).

Hereinafter, a control method according to another embodiment of the present disclosure is described.

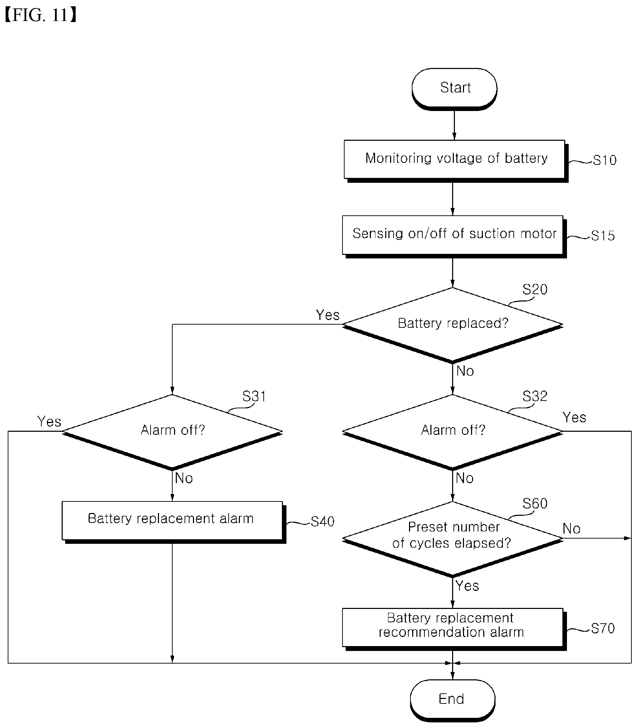

FIG. 11 is a flowchart showing a control method of a cleaner according to another embodiment of the present disclosure.

Referring to FIG. 11, a control method of a cleaner according to an embodiment of the present disclosure includes a monitoring step S10 of monitoring the voltage of the battery Bt, a sensing step S15 of sensing on/off of the suction motor 51 that is operated by power of the battery Bt, and a determining step S20 of determining whether the battery Bt has been replaced on the basis of a voltage difference VD between an off voltage of the battery Bt at a time point at which the suction motor 51 is turned off and an on voltage of the battery Bt at an time point at which the suction motor 51 is turned on.

The control method of a cleaner according to an embodiment may further include an outputting step S75 of outputting a signal enabling a user to recognize that the battery Bt has not been replaced, when one cycle is defined as a sequence in which the suction motor 51 is turned off and then turned on again, and when a state in which the battery Bt has not been replaced exceeds a preset number of cycles.

The monitoring step S10 monitors the voltage of the battery Bt. Specifically, the voltage sensor 160 measures the voltage of the battery Bt at each preset time and provides the measured voltage to the control unit 1800.

In the sensing step S15, the control unit 1800 senses on and off of the suction motor 51.

In the determining step S20, the control unit 1800 determines whether the battery Bt has been replaced on the basis of a voltage difference VD between an off voltage of the battery Bt and an on voltage of the battery Bt. Specifically, in the determining step S20, when the voltage difference VD between the off voltage of the battery Bt and the on voltage of the battery Bt exceeds a first voltage difference, it is determined that the battery Bt has been replaced.

Specifically, in the determining step S20, when the voltage difference VD between the off voltage of the battery Bt and the on voltage of the battery Bt does not exceed the first voltage difference, the control unit determines that the battery Bt has not been replaced.

After the determining step, the control unit 1800 can output a signal enabling a user to recognize whether the battery Bt has been replaced (S45) (S75).

Specifically, in the determining step S20, when it is determined that the battery Bt has been replaced, the control unit 1800 determines whether an alarm is turned off (S31), and when the alarm is not turned off, the control unit 1800 can transmit a message indicating replacement of the battery Bt to the output unit 4 and/or a terminal (S45).

In the determining step S20, when it is determined that the battery Bt has not been replaced, the control unit 1800 determines whether an alarm is turned off (S32), and when the alarm is not turned off, if a preset number of cycles elapses without the battery Bt replaced (S65), the control unit 1800 can output a message recommending replacement of the battery Bt or a message indicating that the spare battery Bt may be discharged through a terminal and/or the output unit 4 (S75).

Therefore, it is possible to prevent a spare battery of a cleaner from being discharged when the spare battery is not replaced for an extended period.

Although exemplary embodiments of the present disclosure were illustrated and described above, the present disclosure is not limited to the specific exemplary embodiments and may be modified in various ways by those skilled in the art without departing from the scope of the present disclosure described in claims, and the modified examples should not be construed independently from the spirit of the scope of the present disclosure.

## Claims

1. A cleaner comprising:
a battery;
a suction motor configured to be operated by power of the battery;
a voltage sensor configured to measure a voltage of the battery; and
a control unit configured to determine whether the battery has been replaced on the basis of the voltage of the battery.

2. The cleaner of claim 1, wherein the control unit determines that the battery has been replaced when the voltage of the battery changes beyond a preset first range within a preset first time.

3. The cleaner of claim 2, further comprising an output unit configured to display a state of the cleaner,
wherein, when the control unit determines that the battery has been replaced, the control unit outputs a control command to cause the output unit to display a signal enabling a user to recognize replacement of the battery.

4. The cleaner of claim 1, wherein the control unit determines that the battery has not been replaced when the voltage of the battery changes within a preset first range within a preset first time.

5. The cleaner of claim 4, further comprising an output unit configured to display a state of the cleaner,
wherein the control unit outputs a control command to cause the output unit to display a signal enabling a user to recognize that the battery has not been replaced, when a state in which the battery has not been replaced is maintained for a second time longer than the first time.

6. The cleaner of claim 4, further comprising a terminal connected with the cleaner through a wireless communication method,
wherein the control unit outputs a control command to cause the terminal to display a signal enabling a user to recognize that the battery has not been replaced, when a state in which the battery has not been replaced is maintained for a second time longer than the first time.

7. The cleaner of claim 1, wherein the control unit determines that the battery has been replaced when a voltage difference between an off voltage of the battery at a time point at which the suction motor is turned off and an on voltage of the battery at a time point at which the suction motor is turned on again after being turned off exceeds a first voltage difference.

8. The cleaner of claim 7, further comprising an output unit configured to display a state of the cleaner,
wherein, when the control unit determines that the battery has been replaced, the control unit outputs a control command to cause the output unit to display a signal enabling a user to recognize replacement of the battery.

9. The cleaner of claim 7, wherein the control unit determines that the battery has not been replaced when the voltage difference is smaller than the first voltage difference.

10. The cleaner of claim 9, further comprising an output unit configured to display a state of the cleaner,
wherein the control unit outputs a control command to cause the output unit to display a signal enabling a user to recognize that the battery has not been replaced, when a state in which the battery has not been replaced is maintained for a second time.

11. The cleaner of claim 9, further comprising a terminal connected with the cleaner through a wireless communication method,
wherein the control unit outputs a control command to cause the terminal to display a signal enabling a user to recognize that the battery has not been replaced, when a state in which the battery has not been replaced is maintained for a second time.

12. The cleaner of claim 9, further comprising an output unit configured to display a state of the cleaner,
the control unit outputs a control command to cause the output unit to display a signal enabling a user to recognize that the battery has not been replaced, when one cycle is defined as a sequence in which the suction motor is turned off and then turned on again, and when a state in which the battery has not been replaced exceeds a preset number of cycles.

13. The cleaner of claim 9, further comprising a terminal connected with the cleaner through a wireless communication method,
the control unit outputs a control command to cause the terminal to display a signal enabling a user to recognize that the battery has not been replaced, when one cycle is defined as a sequence in which the suction motor is turned off and then turned on again, and when a state in which the battery has not been replaced exceeds a preset number of cycles.

14. The cleaner of claim 1, wherein the control unit determines that the battery has been replaced, when a voltage difference between an off voltage of the battery at a time point at which the suction motor is turned off and an on voltage of the battery at a time point at which the suction motor is turned on after the suction motor is turned off and the battery is charged exceeds a first voltage difference.

15. The cleaner of claim 14, further comprising an output unit configured to display a state of the cleaner,
wherein the control unit outputs a control command to cause the output unit to display a signal enabling a user to recognize that the battery has not been replaced, when one cycle is defined as a sequence in which the suction motor is turned off, the battery is charged, and then the suction motor is turned on, and when a state in which the battery has not been replaced exceeds a preset number of cycles.

16. A control method of a cleaner, comprising:
a monitoring step of monitoring a voltage of a battery; and
a determining step of determining whether the battery has been replaced on the basis of a voltage change of the battery within a preset time.

17. The control method of claim 16, wherein the determining step determines that the battery has been replaced when the voltage of the battery changes beyond a preset first range within a preset first time.

18. The control method of claim 16, wherein the determining step determines that the battery has not been replaced when the voltage of the battery changes within a first range within a first time.

19. The control method of claim 17, further comprising an outputting step of outputting a signal enabling a user to recognize whether the battery has been replaced.

20. The control method of claim 19, wherein the outputting step displays, on an output unit, a signal enabling a user to recognize that the battery has not been replaced, when a state in which the battery has not been replaced is maintained for a second time longer than the first time.

21. The control method of claim 19, wherein the outputting step displays, on a terminal, a signal enabling a user to recognize that the battery has not been replaced, when a state in which the battery has not been replaced is maintained for a second time longer than the first time.

22. A control method of a cleaner, comprising:
a monitoring step of monitoring a voltage of a battery;
a sensing step of sensing turning on and turning off of a suction motor that is operated by power of the battery; and
a determining step of determining whether the battery has been replaced on the basis of a voltage difference between an off voltage of the battery at a time point at which the suction motor is turned off and an on voltage of the battery at a time point at which the suction motor is turned on.

23. The control method of claim 22, further comprising an outputting step of outputting a signal enabling a user to recognize that the battery has not been replaced, when one cycle is defined as a sequence in which the suction motor is turned off and then turned on again, and when a state in which the battery has not been replaced exceeds a preset number of cycles.
